# FASCICULE DE BREVET EUROPEEN

(11) **EP 0 638 993 B1**
(45) Date de publication et mention de la délivrance du brevet: **06.05.1998**
(21) Numéro de dépôt: 94401798.7
(22) Date de dépôt: 03.08.1994
(51) Int. Cl.: H03F 1/02, H03F 3/42, H04B 1/16

(54) **Amplificateur détecteur pour système de veille**
Detektorverstärker für Überwachungssystem
Detector amplifier for guarding system

(30) Priorité: 11.08.1993 FR 9309854
(43) Date de publication de la demande: 15.02.1995
(73) Titulaire: Liger, René, F-78270 Limetz-Villetz (FR); Rochon, Pierre, F-75016 Paris (FR)
(72) Inventeur: Liger, René, F-78270 Limetz-Villetz (FR); Rochon, Pierre, F-75016 Paris (FR)
(74) Mandataire: Plaçais, Jean-Yves

(56) Documents cités:
- DE-A- 2 734 945
- FR-A- 2 321 801
- GB-A- 2 181 914
- US-A- 3 152 309
- US-A- 4 590 436
- US-A- 5 041 797

## Description

La présente invention telle qu'elle est définie dans les revendications a pour objet un amplificateur pour système de veille, fonctionnant en permanence et pouvant être "réveillé" par des signaux électroniques d'origine extérieure à l'amplificateur, par exemple : champ magnétique alternatif ou continu, champ électromagnétique modulé ou non, champ infrarouge modulé ou continu, etc...

Lorsque l'amplificateur utilise comme alimentation une pile, il est nécessaire de changer périodiquement celle-ci. Or, dans certains dispositifs, la pile ne peut pas être remplacée, ou bien très difficilement. Il est donc nécessaire, dans ce cas, de prévoir un amplificateur à grand gain, mais à consommation aussi faible que possible. De tels dispositifs sont utilisés dans les dispositifs antivol pour automobile, les dispositifs de transaction électroniques pour le péage des automobiles en circulation urbaine ou routière, de contrôle d'accès pour les piétons; les dispositifs de péage "mains libres" dans les moyens de transport publics ou privés.

Un dispositif de ce type nécessite généralement la détection de plusieurs signaux de natures différentes, notamment :
- des signaux hautes fréquences HF modulés en modulation de fréquence ou d'amplitude;
- des signaux infrarouges; et
- des signaux mécaniques après passage dans un transducteur.

Ces signaux sont en général de faible niveau. Leur traitement nécessite donc une amplification à gain élevé, ce qui requiert en général un courant important. Il est donc essentiel de minimaliser la consommation d'un amplificateur en veille permanente, si l'on veut qu'il fonctionne le plus longtemps possible connaissant la capacité de la pile d'alimentation.

Un tel amplificateur doit pouvoir amplifier des signaux de types différents et pouvant présenter des impédances différentes. La solution classique consiste à prévoir un amplificateur pour chaque entrée, les sorties des amplis étant connectées à un sommateur actif ou passif qui traite les signaux pour délivrer un signal de sortie adéquate sur l'unique sortie dudit amplificateur. Mais, étant donné que dans un tel dispositif chaque étage est personnellement connecté à l'alimentation, cela nécessite l'emploi d'une pile de forte capacité, et donc de grand volume, puisque la consommation est multipliée par le nombre d'étages.

Si l'on prend une pile d'une capacité de 100 mAh, elle peut débiter pendant trois ans, soit sensiblement 26300 heures, une intensité maximale de 3,80 µA. Si, maintenant, l'amplificateur consomme une intensité i=3 µA, et s'il est "réveillé" 24 fois par jours pour effectuer une transaction électronique au cours de laquelle il nécessite une consommation instantanée de 3 mA pendant 100 ms, le courant moyen, pour effectuer ces transactions, s'établit alors à :
I moyenne = 3 x 0,1/3600 = 0,08 µA.

A partir de ces deux exemples, il est possible de déduire que :
- le courant consommé pour effectuer des transactions électroniques est négligeable et il conduirait à une durée de vie théorique d'environ 142 ans pour une pile d'une capacité de 100 mAh;
- la durée de vie de la pile est, en pratique, uniquement liée à deux éléments, à savoir : son courant de fuite et la valeur du courant consommé en permanence par l'amplificateur qu'elle alimente.

Pour les piles modernes au lithium, il est fréquent que les constructeurs indiquent une durée de vie de cinq à dix ans, ce qui, dans le cas d'une capacité de 100 mAh, correspond à un courant de fuite compris entre 1,15 µA et 2,3 µA. Ainsi, pour une pile de 100 mAh de capacité et trois ans de consommation, en supposant que le courant de fuite ne soit que de 1,5 µA, le courant permanent disponible pour activer le dispositif de veille n'est que de 2,3 µA.

Pour tenter de limiter la consommation d'un circuit d'amplification, l'homme de l'art a proposé de mettre en série les étages d'amplification et l'alimentation.

Les brevets allemand DE-A 27 34945 (R.BOSCH) et américain US-A 5 041 797 (D.K.BELCHER) décrivent de tels amplificateurs.

Ceux-ci comprennent :
- un premier étage muni d'une première entrée propre à recevoir un premier signal, et d'une sortie pour délivrer ledit premier signal après amplification et/ou démodulation,
- au moins un second étage connecté en série audit premier étage et muni d'une première entrée propre à recevoir le signal issu de la sortie dudit premier étage, et d'une sortie pour délivrer ledit signal après amplification et/ou démodulation, et
- une alimentation basse tension connectée en série aux étages, et apte à alimenter en courant continu lesdits étages.

L'inconvénient majeur de ce type d'amplificateur réside dans le fait qu'il n'est propre qu'à amplifier un unique signal issu de l'entrée d'un premier étage. L'étage (n) ne sert qu'à amplifier le signal délivré par l'étage (n-1) qui le précède directement.

Si l'on veut traiter plusieurs signaux différents, il faut donc juxtaposer plusieurs amplificateurs de ce type, ce qui nécessite de nouveau plusieurs alimentations.

Le but de la présente invention est de remédier à ces problèmes, en proposant un circuit amplificateur à entrées multiples et sortie unique, propre à consommer un courant d'une intensité sensiblement inférieure à 2,5 µA.

L'invention propose à cet effet un amplificateur détecteur du type décrit précédemment dans lequel :
- chaque étage est alimenté par un même courant continu, ce qui permet de minimaliser, d'une part, le courant consommé par ledit amplificateur détecteur en fonction des caractéristiques de chacun de ses constituants, et d'autre part, la tension d'alimentation basse tension en fonction du gain de chaque étage d'amplification et dudit courant minimalisé, et
- au moins le second étage comprend au moins une seconde entrée propre à recevoir un second signal à amplifier et/ou démoduler.

Ainsi, on réalise un amplificateur à entrées multiples et sortie unique dont les différents étages sont connectés en série à l'alimentation, ce qui permet également de fixer la valeur du courant continu qui alimente lesdits étages.

Selon une autre caractéristique de l'invention, chaque étage comporte au moins un premier circuit apte à amplifier et/ou démoduler, et au moins un second circuit formant impédance de charge pour ledit premier circuit auquel il est connecté, ladite impédance de charge étant choisie de telle sorte que la différence de potentiel aux bornes dudit second circuit soit minimalisée.

Selon encore une autre caractéristique de l'invention, dans chaque étage le premier circuit comprend un premier transistor dont l'émetteur est monté en émetteur commun, et le second circuit dudit étage comprend au moins un second transistor dont le collecteur est connecté au collecteur ou à l'émetteur dudit premier transistor du premier circuit.

Ainsi, selon l'application désirée, le premier transistor pourra être de type NPN ou PNP, selon que l'on est connecté au collecteur ou à l'émetteur du premier transistor du premier circuit.

Selon encore une autre caractéristique de l'invention, le premier circuit de chaque étage comprend en outre au moins une résistance ou un circuit équivalent de petite capacité connecté entre le collecteur et la base du premier transistor dudit premier circuit. Cela permet de maximaliser le gain de chaque étage.

Par ailleurs, toujours selon l'invention, certains seconds circuits comprennent en outre une résistance connectée entre la base et le collecteur du second transistor desdits second circuit, et un condensateur connecté entre la base et l'émetteur de ce même second transistor.

Un tel montage permet, d'une part, d'obtenir une impédance de charge élevée en courant alternatif pour les premiers circuits auxquels les seconds circuits sont respectivement connectés, et d'autre part de réaliser des étages à filtre actif.

De façon particulièrement avantageuse, la sortie du premier circuit d'un étage est connectée au premier circuit de l'étage suivant ledit étage, par un condensateur de couplage.

Ainsi un signal amplifié et/ou démodulé par un étage peut être transmis à l'étage suivant. Cela permet par ailleurs de réaliser un étage à filtre actif. De plus, les fonctions réalisées par chaque étage sont bien isolées les unes des autres. Le dispositif n'est donc pas sujet aux instabilités électroniques.

Dans un mode de réalisation préférentiel de l'invention, l'amplificateur détecteur comprend :
- un premier étage comportant :
   * un premier circuit relié à la masse et apte à démoduler et amplifier un premier signal issu d'une première entrée connectée à la base d'un premier transistor, et à amplifier un second signal issu d'une seconde entrée connectée à l'émetteur dudit premier transistor, et
   * un second circuit connecté à la sortie dudit premier circuit par le collecteur d'un second transistor, et formant impédance de charge pour ledit premier circuit,
et apte à délivrer lesdits premier et/ou second signaux amplifiés et/ou démodulés sur la sortie dudit premier circuit, laquelle forme sortie du premier étage;
- un second étage comportant :
   * un premier circuit connecté d'une part à la sortie du premier étage et d'autre part à l'émetteur du second transistor du second circuit du premier étage, et apte à amplifier d'une part le premier et/ou le second signal issu de la sortie du premier étage, laquelle forme première entrée dudit second étage, et d'autre part un second signal issu d'une seconde entrée dudit second étage, lesquelles entrées sont connectées à la base d'un premier transistor; et
   * un second circuit connecté à la sortie dudit premier circuit par le collecteur d'un second transistor, et formant impédance de charge pour ledit premier circuit;
et apte à délivrer lesdits premier et/ou second signaux amplifiés et/ou démodulés par les premier et/ou second étages, et/ou le troisième signal amplifié par le second étage au niveau de la sortie dudit premier circuit, laquelle forme sortie du second étage;
- un troisième étage comportant :
   * un premier circuit connecté d'une part à la sortie du second étage et d'autre part à l'émetteur du second transistor du second circuit dudit second étage, et apte à amplifier lesdits premiers et/ou seconds et/ou troisièmes signaux issus de la sortie du second étage et débouchant surla base d'un premier transistor, et
   * un second circuit connecté, d'une part, à la sortie dudit premier circuit par le collecteur d'un second transistor, premier circuit pour lequel il forme impédance de charge, et d'autre part, à une alimentation basse tension apte à délivrer un courant continu,
et apte à délivrer sur une sortie lesdits signaux issus du second étage, après amplification, laquelle sortie forme sortie de l'amplificateur détecteur.

Ainsi, trois signaux extérieurs peuvent être traités par l'amplificateur détecteur selon l'invention, puis délivrés sur une sortie.

Dans un tel mode de réalisation, d'une part, chaque transistor fonctionne avec une tension émetteur-collecteur sensiblement égale à 0,5 Volt, et d'autre part, les minimalisations de la tension d'alimentation et du courant continu autorisent une tension d'alimentation sensiblement égale à 2,7 Volts et un courant continu en fonctionnement sensiblement inférieur ou égal à 2,3 µA, pour des gains en amplification sensiblement supérieurs à 30 dB.

La valeur du courant consommé correspond à la limite des spécifications nominales des composants utilisés (par exemple des transistors spécifiés à faible courant du type BC 549C), ce qui permet à un tel amplificateur détecteur de fonctionner avec des caractéristiques constantes, pendant au moins deux années.

D'autres caractéristiques et avantages de l'invention apparaîtront à l'examen de la description détaillée ci-après, et des dessins annexés, sur lesquels :
- la figure 1 est un schéma fonctionnel de l'amplificateur détecteur selon l'invention;
- la figure 2 est un schéma illustrant la réalisation du premier étage d'amplification basse fréquence-démodulation AM/FM;
- la figure 3 illustre un exemple de source de courant propre à alimenter en courant stabilisé le circuit d'amplification-démodulation du premier étage, ou le circuit d'amplification du second étage;
- la figure 4 est un schéma illustrant la réalisation du circuit d'amplification du second étage d'amplification;
- la figure 5 est un schéma illustrant la réalisation du circuit d'amplification du troisième étage d'amplification;
- la figure 6 est un schéma de source à courant constant propre à alimenter le circuit d'amplification du troisième étage;
- la figure 7 est un schéma d'un amplificateur démodulateur selon l'invention regroupant les circuits illustrés sur les figures 2 à 6.

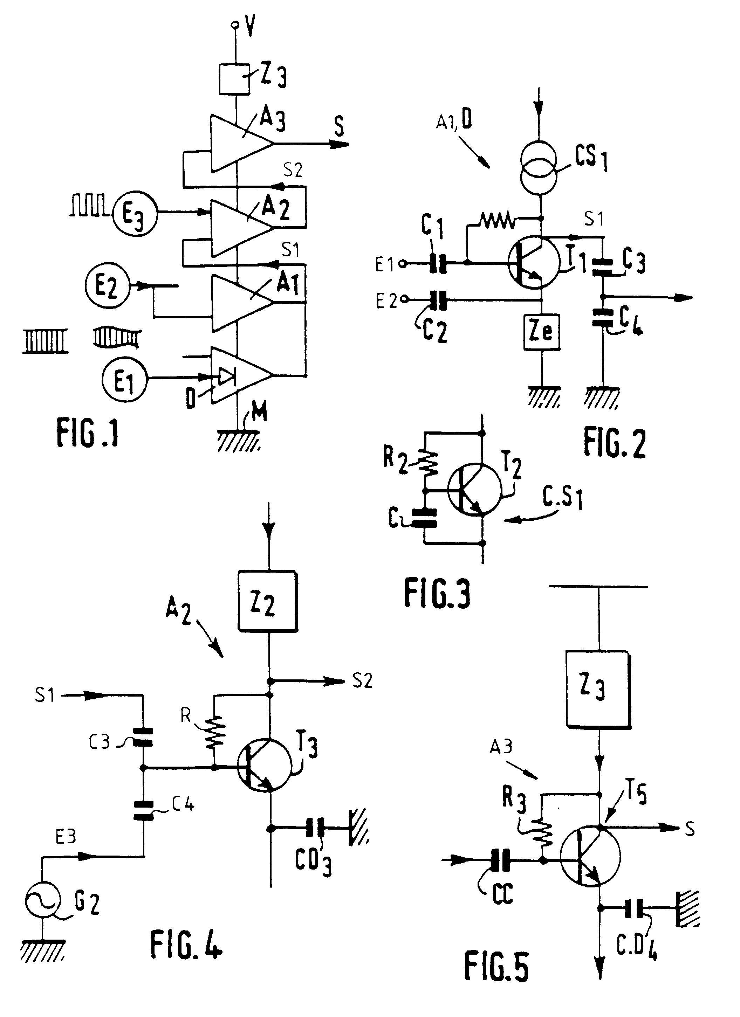

On se réfère tout d'abord à la figure 1.

L'amplificateur-démodulateur selon l'invention comprend, entre la masse M et une source de tension continue V, trois étages :
- un premier étage d'amplification et démodulation comprenant des composants D aptes à démoduler un premier signal arrivant sur sa première entrée E1 et un premier ampli A1 apte à amplifier d'une part le premier signal après démodulation, et d'autre part, un second signal arrivant sur une seconde entrée E2;
- un second étage comprenant un second ampli A2 apte à amplifier un troisième signal arrivant sur une troisième entrée E3 et/ou l'un au moins des signaux issus du premier étage; et
- un troisième étage comprenant un troisième ampli A3 apte à amplifier au moins l'un des signaux issus des premier D, A1 et second A2 étages, et dont la sortie S constitue la sortie de l'amplificateur détecteur.

Dans un tel amplificateur, les signaux extérieurs reçus ne se produisent généralement pas simultanément. Mais si tel était le cas, il serait bien entendu possible de connecter à la sortie S un discriminateur.

Le premier étage D, A1 reçoit, d'une part, sur sa première entrée E1 des signaux hautes fréquences HF, modulés en amplitude AM ou en fréquence FM, et d'autre part, sur sa seconde entrée E2 des signaux basses fréquences BF. Cette première entrée E1 présente une impédance élevée (50 kΩ), et la seconde entrée E2 présente une impédance d'entrée très élevée (1 MΩ);

Le second étage A2 reçoit, par exemple, sur la troisième entrée E3 des impulsions issues d'un capteur infrarouge dont l'impédance de sortie capacitive vaut environ 1000 pF.

Le troisième étage A3 est un étage d'amplification basse fréquence BF à faible impédance d'entrée.

Chaque étage peut être relié en série à la pile V, à travers un ou plusieurs autres étages. La polarisation des différents étages résulte soit de la présence d'une résistance de liaison dont la consommation est proportionnelle au carré de l'intensité du courant (mais l'intensité est faible), soit de la présence d'une source de courant désignée par CS dans ce qui suit, laquelle comprend elle-même au moins un transistor T qui a l'avantage de délivrer un courant stable, comme cela sera expliqué ci-dessous.

Alors que dans la technique antérieure, chaque fonction consommait son propre courant, les courants d'alimentation étant différents selon l'étage, dans l'amplificateur selon l'invention, tous les étages D, A1-A3 sont, du point de vue du courant d'alimentation, strictement en série et par conséquent traversés par le même courant continu d'alimentation qui, pour une tension V supérieure ou égale à 2,7 Volts, est d'une intensité inférieure ou égale à 2 µA.

On se réfère maintenant aux figures 2 à 6 pour décrire en détail les différents étages.

La figure 2 est un schéma illustrant un mode de réalisation possible du premier étage.

Le premier étage D, A1 comprend un premier circuit d'amplification et démodulation composé des éléments C1, C2, R, T1 et Ze, et d'un second circuit CS1 délivrant un courant stabilisé audit premier circuit. Un tel second circuit CS1 est illustré sur la figure 3.

Dans ce qui suit, les éléments C sont des condensateurs, les éléments R sont des résistances, les éléments T sont des transistors, et les éléments Z sont des impédances capacitives ou résistives.

Dans le premier circuit, R relie la base du transistor T1 à son collecteur, ce qui permet de réaliser la fonction d'amplification.

L'émetteur de T1 est couplé à la masse du circuit par Ze. T1 est donc monté en émetteur commun.

Les signaux traités par ce premier circuit sont délivrés au niveau de la sortie S1.

Le premier étage est connecté au second étage par C3, tandis que C4 couple l'entrée E3 au second étage A2.

Le courant traversant le transistor T1 étant très faible, typiquement 2 µA, ledit transistor T1 fonctionne dans la zone non linéaire de sa caractéristique.

Pour les hautes fréquences HF, (F > 60 kHz), le couple source de courant CS1, capacités équivalentes C3, C4 constitue un circuit intégrateur procurant une fonction de démodulation aussi bien en amplitude qu'en fréquence, le courant absorbé étant, pour les alternances positives du signal, supérieur à celui fourni par la source de courant alternatif CS1. L'impédance d'entrée au niveau de E1 reste assez élevée (≈ 50 kΩ) compte tenu du faible courant traversant T1 et ceci même lorsque l'émetteur est relié directement au zéro Volt (Ze=0).

Pour les basses fréquences BF (F < 5 kHz), la capacité C3, C4 représente une valeur d'impédance élevée. Ainsi, T1 fonctionne uniquement en régime d'amplification puisque CS1 impose son impédance. C3 et C4 se comportent comme un pont diviseur capacitif pour le signal de sortie S1 du premier étage, ce qui n'est pas trop pénalisant puisque le gain de l'étage est élevé.

L'impédance d'entrée de T1 est très élevée ( > 1MΩ), pour les signaux BF, et C1 (environ 1000 pF) convient comme condensateur de liaison basse fréquence (f > 500 Hz) si l'on veut utiliser l'entrée E1.

L'entrée E2 utilise le couplage sur l'émetteur de T1. Un capteur à bobine peut être inséré directement dans l'émetteur étant donné le faible courant traversant T1.

A titre d'exemple, on a représenté sur la figure 3 une solution convenable pour réaliser la source de courant CS1 formant impédance de charge élevée pour le premier circuit. Le transistor T2 est un transistor de type NPN. Le condensateur C maintient la tension base-émetteur constante dans la bande de fréquences utilisée. La tension aux bornes de T2 est constante et limitée à environ 475 mV, de sorte que la chute de tension continue à ses bornes est très faible par rapport à celle que l'on aurait avec une simple résistance de même impédance.

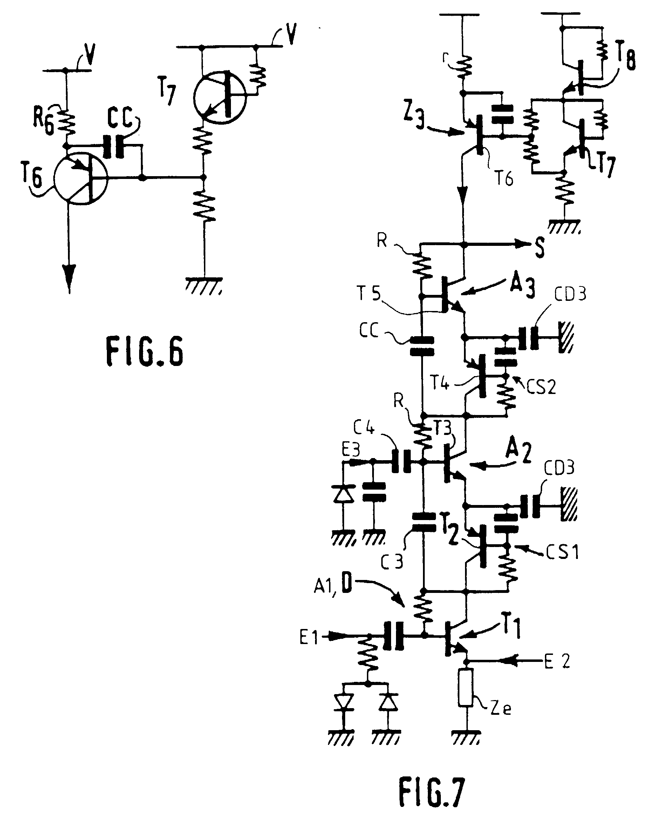

Sur la figure 4 se trouve illustré le second étage d'amplification A2 des signaux issus de l'entrée E3 et du premier étage D, A1.

Les signaux traités par ce second étage A2 sont délivrés au niveau de la sortie S2.

Comme au premier étage, on reconnaît un premier circuit réalisant l'amplification, composé de R et T3, et un second circuit Z2 délivrant un courant stabilisé audit premier circuit et formant impédance de charge pour ce premier circuit. Ce second circuit est identique à celui CS1 du premier étage décrit précédemment et illustré sur la figure 3.

L'émetteur du transistor T3 du premier circuit est à l'image du transistor T1 du premier circuit du premier étage couplé à la masse par l'intermédiaire du condensateur CD3. T3 est donc également monté en émetteur commun. L'impédance d'entrée de T3, travaillant en BF (F < 5 kHz) est très élevée, avec un courant à peu près égal à 2 µA.

Le générateur G2 connecté à l'entrée E3 est constitué par la jonction inversée d'une photodiode infrarouge. G2 présente une capacité suffisamment élevée par rapport à C3, C4 pour que le premier étage D, A1 fonctionne correctement en démodulation. C4 représente pour G2 la capacité de couplage au deuxième étage A2. Ce couplage se fait dans de bonnes conditions car l'impédance vue du côté du générateur G2 est très élevée.

Sur la figure 5 se trouve illustré le troisième étage d'amplification A3 des signaux issus des premier et second étages. Cet étage fonctionne en basse fréquence BF, et comprend également un premier et un second circuits.

Les signaux traités par ce troisième étage sont délivrés au niveau de la sortie S.

Le premier circuit formant circuit d'amplification du troisième étage A3 est identique au premier circuit du second étage A2. On reconnaît le transistor T5 monté en émetteur commun. CC est le condensateur de couplage qui assure la transmission des signaux issus des étages précédents au niveau du troisième étage.

T5 travaillant en BF (F < 5 kHz), son impédance d'entrée est élevée.

Le second circuit est représenté par Z3. Il réalise l'impédance de charge élevée du premier circuit, et peut être constituée par une résistance de quelques centaines de kΩ si la tension d'alimentation V est continue et stable, ou une source de courant telle que celle qui a été représentée sur la figure 3. Dans ce cas, l'intensité i est définie par la valeur de R pourvu que V soit suffisamment élevée (3 volts par exemple).

Mais, lorsque ces conditions ne sont pas remplies, une source de courant CS3 est nécessaire. Un exemple de réalisation d'une telle source est illustré figure 6.

Les transistors T6 et T7 fixent la valeur de l'intensité du courant d'alimentation de l'ensemble du circuit et cela quelle que soit la valeur de la tension V, pourvu, bien entendu que V soit supérieure ou égale à la valeur de fonctionnement soit 2,7 Volts environ. L'avantage de cette solution est que la source de courant T6 fonctionne avec une tension de déchet très faible, ce qui permet au circuit de fonctionner avec une tension d'alimentation aussi petite que 2,7 Volts.

On retrouve sur la figure 7 les différents éléments qui viennent d'être décrits séparément, avec quelques perfectionnements mineures tels que l'entrée E1 du premier étage qui est couplée à la masse par une résistance et un jeu de diodes, et le second circuit du troisième étage réalisant CS3 auquel on a rajouté un transistor T8 et quelques résistances afin d'améliorer la stabilité du courant délivré par le troisième étage.

Dans cet amplificateur détecteur, tous les transistors fonctionnent avec une tension émetteur-collecteur minimale voisine de 0,5 Volt, ce qui permet de minimiser la consommation car la résistance de polarisation base-collecteur est le siège d'une chute de tension très faible, ce qui permet de minimiser la tension de fonctionnement.

Par ailleurs, le fait que les premiers circuits d'amplification et/ou de démodulation comprennent un transistor dont le collecteur est couplé à une impédance de charge élevée en alternatif, et une résistance qui couple la base du transistor et son collecteur, autorise une optimalisation du gain de chaque étage. Ainsi, selon les caractéristiques des composants utilisés, les gains d'amplification d'un étage peuvent atteindre 50 dB.

Enfin, dans un tel amplificateur, les différents étages sont couplés en série par des condensateurs de couplage C3 et CC. Cela permet, d'une part, d'assurer la transmission d'un signal traité par un étage n à l'étage suivant n+1, et d'autre part d'isoler les étages les uns des autres pour ne pas perturber leurs fonctions respectives.

Les remarquables performances d'un tel amplificateur lui permettent de fonctionner de façon autonome avec des caractéristiques constantes pendant des durées largement supérieures à deux ans, en utilisant une pile de 2,7 Volts en continu.

La présente invention peut être appliquée dans tous les dispositifs électroniques à alimentation autonome, généralement une pile, dont l'utilisation implique qu'ils restent en veille permanente, en général pendant des périodes de temps importantes (souvent supérieure à un an) et qui, durant ces périodes de veille doivent pouvoir être activés par un ou des signaux électroniques dont l'origine est extérieure à l'amplificateur.

Ainsi, l'invention s'applique, par exemple, aux dispositifs antivol pour automobile, aux dispositifs transactionnels de type péage, ou encore, aux dispositifs de contrôle d'accès.

Il va de soi que de nombreuses variantes peuvent être apportées, notamment par substitution de moyens techniques équivalents, sans sortir pour cela du cadre de l'invention défini dans les revendications.

## Revendications

1. Amplificateur détecteur, notamment pour dispositif électronique de veille, du type comprenant :
- un premier étage (D, A1) muni d'une première entrée (E1) propre à recevoir un premier signal, et d'une sortie (S1) pour délivrer ledit premier signal après amplification et/ou démodulation,
- au moins un second étage (A3) connecté en série audit premier étage et muni d'une première entrée propre à recevoir le signal issu de la sortie (S1) dudit premier étage, et d'une sortie (S2) pour délivrer ledit signal après amplification et/ou démodulation, et
- une alimentation basse tension (V) connectée en série aux étages, et apte à alimenter en courant continu lesdits étages,
caractérisé en ce que chaque étage (D, A1, A2, A3) est alimenté par un même courant continu, ce qui permet de minimaliser, d'une part, le courant consommé par ledit amplificateur détecteur en fonction des caractéristiques de chacun de ses constituants, et d'autre part, la tension d'alimentation basse tension en fonction du gain de chaque étage d'amplification et dudit courant minimalisé,
et en ce qu'au moins le second étage (A2) comprend au moins une seconde entrée (E3) propre à recevoir un second signal à amplifier et/ou démoduler.

2. Amplificateur détecteur selon la revendication 1, caractérisé en ce que chaque étage (D, A1, A2, A3) comporte au moins un premier circuit apte à amplifier et/ou démoduler, et au moins un second circuit (CSi ou Zi) formant impédance de charge pour ledit premier circuit auquel il est connecté, de telle sorte que la différence de potentiel aux bornes dudit second circuit soit minimalisée.

3. Amplificateur détecteur selon la revendication 2, caractérisé en ce que dans chaque étage (D, A1, A2, A3) le premier circuit comprend un premier transistor (T1, T3, T5) dont l'émetteur est monté en émetteur commun, et
en ce que dans chaque étage (D, A1, A2, A3) le second circuit (CSi) comprend au moins un second transistor ( T2, T4, T6) dont le collecteur est connecté au collecteur ou à l'émetteur dudit premier transistor (T1, T3, T5) du premier circuit.

4. Amplificateur détecteur selon l'une des revendications 2 et 3, caractérisé en ce que le premier circuit de chaque étage comprend en outre au moins une résistance (R) ou un circuit équivalent de petite capacité connecté entre le collecteur et la base du premier transistor (T1, T3, T5) dudit premier circuit,
et en ce que certains seconds circuits (CS1, CS2) comprennent en outre une résistance connectée entre la base et le collecteur du second transistor (T2, T4) desdits seconds circuits, et un condensateur (CD3) connecté entre la base et l'émetteur de ce même second transistor,
ce qui permet d'obtenir une impédance de charge élevée en courant alternatif pour les premiers circuits auxquels les seconds circuits sont respectivement connectés, lesdits premiers circuits assurant ainsi une amplification à gain élevé des premiers et seconds signaux, et réalisant avec lesdits seconds circuits des étages à filtre actif.

5. Amplificateur détecteur selon l'une des revendications 2 à 4, caractérisé en ce que la sortie (S1) du premier circuit d'un étage est connectée au premier circuit de l'étage suivant ledit étage, par un condensateur de couplage (C3, CC),
ce qui permet de transmettre le signal amplifié et/ou démodulé d'un étage à l'étage suivant.

6. Amplificateur détecteur selon l'une des revendications 2 à 5, caractérisé en ce que l'émetteur du second transistor (T2, T4) d'un second circuit d'un étage est connecté à l'émetteur du premier transistor (T3, T5) du premier circuit de l'étage suivant ledit étage.

7. Amplificateur détecteur selon l'une des revendications 1 à 6, caractérisé en ce qu'il comprend :
- un premier étage (D, A1) comportant :
* un premier circuit relié à la masse (M) et apte à démoduler et amplifier un premier signal (S1) issu d'une première entrée (E1) connectée à la base d'un premier transistor (T1), et à amplifier un second signal (E2) issu d'une seconde entrée (E2) connectée à l'émetteur dudit premier transistor (T1), et
* un second circuit (CS1) connecté à la sortie (S1) dudit premier circuit par le collecteur d'un second transistor (T2), et formant impédance de charge pour ledit premier circuit,
et apte à délivrer lesdits premier et/ou second signaux amplifiés et/ou démodulés sur la sortie (S1) dudit premier circuit, laquelle forme sortie du premier étage;
- un second étage (A2) comportant :
* un premier circuit connecté d'une part à la sortie (S1) du premier étage et d'autre part à l'émetteur du second transistor (T2) du second circuit (CS1) du premier étage, et apte à amplifier d'une part le premier et/ou le second signal issu de la sortie (S1) du premier étage, laquelle forme première entrée dudit second étage (A2), et d'autre part un second signal issu d'une seconde entrée (E3) dudit second étage, lesquelles entrées sont connectées à la base d'un premier transistor (T3); et
* un second circuit (CS2 ou Z2) connecté à la sortie dudit premier circuit par le collecteur d'un second transistor (T4), et formant impédance de charge pour ledit premier circuit;
et apte à délivrer lesdits premier et/ou second signaux amplifiés et/ou démodulés par les premier (D, A1) et/ou second (A2) étages, et/ou le troisième signal amplifié par le second étage (A2) au niveau de la sortie (S2) dudit premier circuit, laquelle forme sortie du second étage;
- un troisième étage (A3) comportant :
* un premier circuit connecté d'une part à la sortie (S2) du second étage et d'autre part à l'émetteur du second transistor (T4) du second circuit (CS2 ou Z2) dudit second étage, et apte à amplifier lesdits premiers et/ou seconds et/ou troisièmes signaux issus de la sortie (S2) du second étage et débouchant sur la base d'un premier transistor (T5), et
* un second circuit (CS3 ou Z3) connecté, d'une part, à la sortie (S) dudit premier circuit par le collecteur d'un second transistor (T6), premier circuit pour lequel il forme impédance de charge, et d'autre part, à une alimentation basse tension (V) apte à délivrer un courant continu,
et apte à délivrer sur une sortie lesdits signaux issus du second étage, après amplification, laquelle sortie (S) forme sortie de l'amplificateur détecteur.

8. Amplificateur détecteur selon la revendication 7, caractérisé en ce que le second circuit (CS3) du troisième étage (A3) comprend en outre au moins un troisième transistor (T7) dont le collecteur et l'émetteur sont connectés au second transistor (T6) par l'intermédiaire de résistances, et un quatrième transistor (T8) dont l'émetteur est connecté au collecteur du troisième transistor (T7) et le collecteur est connecté à l'alimentation basse tension (V), ce qui permet de fixer la valeur du courant continu alimentant lesdits premier (D, A1), second (A2) et troisième (A3) étages.

9. Amplificateur détecteur selon la revendication 8, caractérisé en ce que chaque transistor (T1-T8) fonctionne avec une tension émetteur-collecteur sensiblement égale à 0,5 Volt.

10. Amplificateur détecteur selon la revendication 9, caractérisé en ce que les minimalisations de la tension d'alimentation et du courant continu autorisent une tension d'alimentation sensiblement égale à 2,7 Volts et un courant continu en fonctionnement sensiblement inférieur ou égal à 2,3 µA, pour des gains en amplification sensiblement supérieurs à 30 dB.

## Patentansprüche

1. Detektorverstärker, insbesondere für elektronische Überwachungssysteme, umfassend:
- eine erste Stufe (D, A1), ausgestattet mit einem ersten Eingang (E1), der ein erstes Signal empfangen kann, und einen Ausgang (S1), um dieses erste Signal nach Verstärkung und/oder Demodulation zu liefern,
- wenigstens eine zweite Stufe (A3), in Reihe geschaltet mit der genannten ersten Stufe und ausgestattet mit einem ersten Eingang, der das von dem Ausgang (S1) der genannten ersten Stufe stammende Signal empfangen kann, und einen Ausgang (S2), um dieses Signal nach Verstärkung und/oder Demodulation zu liefern, und
- eine Niederspannungsversorgung (V), in Reihe mit den Stufen verbunden und fähig, besagten Stufen mit Gleichstrom zu versorgen,
**dadurch gekennzeichnet,** daß jede Stufe (D, A1, A2, A3) durch denselben Gleichstrom versorgt wird, was ermöglicht, einerseits den durch den Detektorverstärker verbrauchten Strom in Abhängigkeit von den Kennwerten jedes seiner Bestandteile zu minimalisieren, und andererseits die Niederspannung-Versorgungsspannung in Abhängigkeit von dem Verstärkungsfaktor jeder Verstärkerstufe und dem besagten minimalisierten Strom zu minimieren,
und dadurch, daß wenigstens die zweite Stufe (A2) wenigstens einen zweiten Eingang (E3) umfaßt, der ein zweites zu verstärkendes und/oder zu demodulierendes Signal empfangen kann.

2. Detektorverstärker nach Anspruch 1, dadurch gekennzeichnet, daß jede Stufe (D, A1, A2, A3) wenigstens eine erste Schaltung zum Verstärken und/oder Demodulieren umfaßt, und wenigstens eine zweite Schaltung (CSi oder Zi), die eine Belastungsimpedanz für die genannte erste Schaltung bildet, mit der sie verbunden ist, so daß die Potentialdifferenz an den Anschlüssen dieser zweiten Schaltung minimiert wird.

3. Detektorverstärker nach Anspruch 2, dadurch gekennzeichnet, daß in jeder Stufe (D, A1, A2, A3) die erste Schaltung einen ersten Transistor (T1, T3, T5) umfaßt, der in Emitterschaltung angeschlossen bzw. geschaltet ist,
und dadurch, daß in jeder Stufe (D, A1, A2, A3) die zweite Schaltung (CSi) wenigstens einen zweiten Transistor (T2, T4, T6) umfaßt, dessen Kollektor mit dem Kollektor oder dem Emitter des genannten ersten Transistors (T1, T3, T5) verbunden ist.

4. Detektorverstärker nach einem der Ansprüche 2 und 3, dadurch gekennzeichnet, daß die erste Schaltung jeder Stufe außerdem wenigstens einen Widerstand (R) oder eine äquivalente Schaltung von kleiner Kapazität umfaßt, eingeschaltet zwischen den Kollektor und die Basis des ersten Transistors (T1, T3, T5) der genannten ersten Schaltung,
und dadurch, daß bestimmte zweite Schaltungen (CS1, CS2) außerdem einen Widerstand umfassen, eingeschaltet zwischen die Basis und den Kollektor des zweiten Transistors (T2, T4) der genannten zweiten Schaltungen, und einen Kondensator (CD3), eingeschaltet zwischen die Basis und den Emitter dieses zweiten Transistors,
was ermöglicht, eine hohe Wechselstrom-Ladungsimpedanz für die ersten Schaltungen zu erhalten, an die die zweiten Schaltungen jeweils angeschlossen sind, wobei diese ersten Schaltungen infolgedessen eine Verstärkung mit hohem Verstärkungsfaktor der ersten und zweiten Signale sicherstellen und mit den genannten zweiten Schaltungen Aktivfilterstufen bilden.

5. Detektorverstärker nach einem der Ansprüche 2 bis 4, dadurch gekennzeichnet, daß der Ausgang (S1) der ersten Schaltung einer Stufe mit der ersten Schaltung der dieser Stufe folgenden Stufe durch einen Kopplungskondensator (C3, CC) verbunden ist, was ermöglicht, ein verstärktes und/oder demoduliertes Signal von einer Stufe zu nächsten Stufe zu übertragen.

6. Detektorverstärker nach einem der Ansprüche 2 bis 5, dadurch gekennzeichnet, daß der Emitter des zweiten Transistors (T2, T4) einer zweiten Schaltung einer Stufe mit dem Emitter des ersten Transistors (T3, T5) der ersten Schaltung der dieser Stufe folgenden Stufe verbunden ist.

7. Detektorverstärker nach einem der Ansprüche 1 bis 6, dadurch gekennzeichnet, daß er umfaßt:
- eine erste Stufe (D, A1), enthaltend:
* eine erste Schaltung, verbunden mit der Masse (M) und fähig, ein erstes Signal (S1) zu demodulieren und zu verstärken, das von einem ersten Eingang (El) stammt, der mit der Basis eines ersten Transistors (T1) verbunden ist, und ein zweites Signal (S2) zu verstärken, das von einem zweiten Eingang (E2) stammt, der mit dem Emitter dieses ersten Transistor (T1) verbunden ist, und
* eine zweite Schaltung (CS1), die mit dem Ausgang (S1) der genannten ersten Schaltung durch den Kollektor eines zweiten Transistors (T2) verbunden ist und eine Belastungsimpedanz für die erste Schaltung bildet,
und fähig, die genannten verstärkten und/oder demodulierten Signale, das erste und/oder das zweite, auf dem Ausgang (S1) der genannten ersten Schaltung zu liefern, der den Ausgang der ersten Stufe bildet;
- eine zweite Stufe (A2), enthaltend:
* eine erste Schaltung, einerseits verbunden mit dem Ausgang (S1) der ersten Stufe und andererseits mit dem Emitter des zweiten Transistors (T2) der zweiten Schaltung (CS1) der ersten Stufe und fähig, einerseits das erste und/oder zweite Signal zu verstärken, das von dem Ausgang (S1) der ersten Stufe stammt, der den ersten Eingang der genannten zweiten Stufe (A2) bildet, und andererseits ein zweites Signal zu verstärken, das von einem zweiten Eingang (E3) der genannten zweiten Stufe stammt, wobei diese Eingänge mit der Basis eines ersten Transistors (T3) verbunden sind, und
* eine zweite Schaltung (CS2 oder Z2), die mit dem Ausgang der ersten Schaltung durch den Kollektor eines zweiten Transistors (T4) verbunden ist und eine Belastungsimpedanz für die erste Schaltung bildet;
und fähig, das genannte, durch die erste (D, A1) und/oder zweite (A2) Stufe verstärkte und/oder demodulierten erste und/oder zweite Signal, und/oder das dritte Signal, verstärkt durch die zweite Stufe (A2), am Ausgang (S2) der ersten Schaltung, der den Ausgang der zweiten Stufe bildet, zu liefern;
- eine dritte Stufe, enthaltend:
* eine erste Schaltung, einerseits verbunden mit dem Ausgang (S2) der zweiten Stufe und andererseits mit dem Emitter des zweiten Transistors (T4) der zweiten Schaltung (CS2 oder Z2) der zweiten Stufe und fähig, die genannten ersten und/oder zweiten und/oder dritten Signale zu verstärken, die von dem Ausgang (S2) der genannten zweiten Stufe stammen und an die Basis eines ersten Transistors (T5) gelegt werden, und
* eine zweite Schaltung (CS3 oder Z3), einerseits durch den Kollektor eines zweiten Transistors (T6) mit dem Ausgang (S) der genannten ersten Schaltung verbunden, erste Schaltung, für die sie Belastungsimpedanz bildet, und andererseits mit einer Niederspannungsversorgung (V) verbunden, die einen Gleichstrom liefert,
und fähig, auf einem Ausgang die genannten, von der zweiten Stufe stammenden Signale zu liefern, nach Verstärkung, wobei dieser Ausgang (S) den Ausgang des Detektorverstärkers bildet.

8. Detektorverstärker nach Anspruch 7, dadurch gekennzeichnet, daß die zweite Schaltung (CS3) der dritten Stufe (A3) außerdem wenigstens einen dritten Transistor (T7) umfaßt, dessen Kollektor und Emitter durch Widerstände mit dem zweiten Transistor (T6) verbunden sind, und einen vierten Transistor (T8), von dem der Emitter mit dem Kollektor des dritten Transistors (T7) und der Kollektor mit der Niederspannungsversorgung (V) verbunden ist, was ermöglicht, den Wert des Gleichstroms festzulegen, der die erste (D, A1), zweite (A2) und dritte (A3) Stufe versorgt.

9. Detektorverstärker nach Anspruch 8, dadurch gekennzeichnet, daß jeder Transistor (T1-T8) mit einer Emitter-Kollektor-Spannung von im wesentlichen 0,5V arbeitet.

10. Detektorverstärker nach Anspruch 9, dadurch gekennzeichnet, daß die Minimierungen der Versorgungsspannung und des Gleichstroms eine Versorgungsspannung von im wesentlichen gleich 2,7V und einen Betriebsgleichstrom von im wesentlichen gleich 2,3µA zulassen, für Verstärkungsfaktoren, die wesentlich höher sind als 30dB.

## Claims

1. Detector-amplifier, in particular for an electronic monitoring device, of the type which comprises:
- a first stage (D, A1) which is provided with a first input (E1) which can receive a first signal, and an output (S1) to emit the first signal after amplification and / or demodulation;
- at least a second stage (A3) which is connected in series to the first stage and is provided with a first input which can receive the signal emitted by the output (S1) of the first stage, and with an output (S2) to emit this signal after amplification and / or demodulation; and
- a low voltage supply (V) which is connected in series to the stages, and which can supply these stages with direct current,
characterised in that each stage (D, A1, A2, A3) is supplied by a single direct current, which makes it possible to minimise firstly the current consumed by the detector-amplifier according to the features of each of its components, and secondly the low voltage power supply according to the gain of each amplification stage and to the minimised current,
and in that at least the second stage (A2) comprises at least a second input (E3) which can receive a second signal to be amplified and / or demodulated.

2. Detector-amplifier according to claim 1, characterised in that each stage (D, A1, A2, A3) comprises at least a first circuit which can amplify and / or demodulate, and at least a second circuit (CSi or Zi) which constitutes the load impedance for the first circuit, to which it is connected, such that the difference in potential at the terminals of the second circuit is minimised.

3. Detector-amplifier according to claim 2, characterised in that in each stage (D, A1, A2, A3) the first circuit comprises a first transistor (T1, T3, T5), the emitter of which is fitted as a common emitter, and
in that in each stage (D, A1, A2, A3) the second circuit (CSi) comprises at least a second transistor (T2, T4, T6), the collector of which is connected to the collector or to the emitter of the first transistor (T1, T3, T5) of the first circuit.

4. Detector-amplifier according to one of claims 2 and 3, characterised in that the first circuit of each stage additionally comprises at least one resistor (R) or an equivalent small capacity circuit connected between the collector and the base of the first transistor (T1, T3, T5) of the first circuit,
and in that specific second circuits (CS1, CS2) additionally comprise a resistor which is connected between the base and the collector of the second transistor (T2, T4) of the second circuits, and a capacitor (CD3) which is connected between the base and the emitter of the second transistor,
which makes it possible to obtain a high alternating current load impedance for the first circuits, to which the second circuits are connected, the first circuits thus providing high-gain amplification of the first and second signals, and constituting active filter stages together with the second circuits.

5. Detector-amplifier according any one of claims 2 to 4, characterised in that the output (S1) of the first circuit of a stage is connected to the first circuit of the stage which follows this stage, by a connection capacitor (C3, CC),
which makes it possible to transmit the amplified and / or demodulated signal from one stage to the following stage.

6. Detector-amplifier according to any one of claims 2 to 5, characterised in that the emitter of the second transistor (T2, T4) of a second circuit of a stage is connected to the emitter of the first transistor (T3, T5) of the first circuit of the stage which follows this stage.

7. Detector-amplifier according to any one of claims 1 to 6, characterised in that it comprises:
- a first stage which consists of:
* a first circuit which is connected to earth (M) and which can demodulate and amplify a first signal (S1) obtained from a first input (E1) connected to the base of a first transistor (T1), and can amplify a second signal (E2) obtained from a second input (E2) connected to the emitter of the first transistor (T1); and
* a second circuit (CS1) connected to the output (S1) of the first circuit by the collector of a second transistor (T2), and constituting a load impedance for the first circuit,
and which can emit the first and / or second amplified and / or demodulated signals at the output (S1) of the first circuit, which constitutes the output of the first stage;
- a second stage (A2) which consists of:
* a first circuit connected firstly to the output (S1) of the first stage and secondly to the emitter of the second transistor (T2) of the second circuit (CS1) of the first stage, and which can amplify firstly the first and / or second signal emitted by the output (S1) of the first stage, which constitutes the first input of the second stage (A2), and secondly a second signal obtained constitutes a second input (E3) of the second stage, which inputs are connected to the base of a first transistor (T3); and
* a second circuit (CS2 or Z2) connected to the output of the first circuit by the collector of a second transistor (T4), and constituting a load impedance for the first circuit:
and which can emit the first and / or second signals amplified and / or demodulated by the first (D, Al) and / or second (A2) stages, and / or the third signal amplified by the second stage (A2), at the output (S2) of the first circuit, which constitutes the output of the second stage;
- a third stage (A3) which consists of:
* a first circuit connected firstly to the output (S2) of the second stage and secondly to the emitter of the second transistor (T4) of the second circuit (CS2 or Z2) of the second stage, and which can amplify the first and / or second and / or third signals emitted by the output (S2) of the second stage, and leading to the base of a first transistor (T5), and
* a second circuit (CS3 or Z3) connected firstly to the output (S) of the first circuit by the collector of a second transistor (T6), for which first circuit it constitutes a load impedance, and secondly to a low voltage supply (V) which can supply direct current,
and which can emit at an output the signals obtained from the second stage, after amplification, which output (S) constitutes the output of the detector-amplifier.

8. Detector-amplifier according to claim 7, characterised in that the second circuit (CS3) of the third stage (A3) additionally comprises at least a third transistor (T7), the collector and the emitter of which are connected to the second transistor (T6) by means of resistors, and a fourth transistor (T8), the emitter of which is connected to the collector of the third transistor (T7), and the collector is connected to the low voltage supply (V), which makes it possible to establish the value of the direct current which supplies the first (D, A1), second (A2) and third (A3) stages.

9. Detector-amplifier according to claim 8, characterised in that each transistor (T1 - T8) operates with an emitter-collector voltage which is substantially 0.5 volt.

10. Detector-amplifier according to claim 9, characterised in that the minimisations of the supply voltage and of the direct current permit a supply voltage which is substantially 2.7 volts, and a direct current in operation which is substantially 2.3 µA or less, for amplification gains which are substantially greater than 30 dB.
